# FASCICULE DE BREVET EUROPEEN

(11) **EP 3 961 236 B1**
(45) Date de publication et mention de la délivrance du brevet: **04.01.2023**
(21) Numéro de dépôt: 21192913.8
(22) Date de dépôt: 24.08.2021
(51) Int. Cl.: G01R 33/032, G01R 33/26, G01R 33/60

(54) **MAGNETOMETRE EN POLARISATION ELLIPTIQUE AVEC DEUX COMPOSANTES DE CHAMP RADIOFREQUENCE POUR DETECTION DE RESONANCE PARAMETRIQUE EN ABSORPTION**
ELLIPTISCH POLARISIERTES MAGNETOMETER MIT ZWEI HOCHFREQUENZ-FELDKOMPONENTEN ZUR DETEKTION DER PARAMETRISCHEN ABSORPTIONSRESONANZ
MAGNETOMETER IN ELLIPTIC POLARISATION WITH TWO RADIOFREQUENCY FIELD COMPONENTS FOR DETECTING PARAMETRIC RESONANCE IN ABSORPTION

(30) Priorité: 27.08.2020 FR 2008751
(43) Date de publication de la demande: 02.03.2022
(73) Titulaire: Commissariat à l'énergie atomique et aux énergies alternatives, 75015 Paris (FR)
(72) Inventeur: LE GAL, Gwenael, 38054 GRENOBLE Cedex 09 (FR); PALACIOS LALOY, Agustin, 38054 GRENOBLE Cedex 09 (FR)
(74) Mandataire: Brevalex

(56) Documents cités:
- EP-A1- 3 364 204
- EP-A1- 3 524 990
- FRANÇOIS BEATO ET AL: "parametric-resonance magnetometer based on atomic alignment", PHYSICAL REVIEW A, vol. 98, no. 5, 26 novembre 2018 (2018-11-26), XP055607399, ISSN: 2469-9926, DOI: 10.1103/PhysRevA.98.053431

## Description

### DOMAINE TECHNIQUE

Le domaine de l'invention est celui des magnétomètres à pompage optique et plus particulièrement celui des magnétomètres à résonance paramétrique.

### TECHNIQUE ANTÉRIEURE

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :
1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.
2) Ces états atomiques évoluent sous l'effet du champ magnétique, notamment sous l'effet Zeeman qui correspond à des décalages des niveaux d'énergie en fonction du champ magnétique auquel les atomes sont soumis.
3) Les propriétés optiques du milieu atomique subissent alors des modifications qui dépendent de l'état des atomes. On peut ainsi par une mesure optique, par exemple par une mesure d'absorption optique, remonter au décalage Zeeman subi et en déduire une mesure du champ magnétique dans lequel est plongée la cellule.

Selon les différentes configurations possibles des magnétomètres à pompage optique existants, on distingue une mesure du module, aussi appelée norme, du champ magnétique pour les magnétomètres scalaires ou une mesure des différentes composantes du champ magnétique pour les magnétomètres vectoriels.

Le niveau de sensibilité, aussi appelé bas bruit, et de justesse atteignables avec de tels magnétomètres à pompage optique sont très remarquables et nettement plus favorables que ceux de la plupart des autres technologies de mesure magnétique (magnétomètres à entrefer dits « fluxgate » en anglais, effet Hall, magnétorésistance, etc.). Seul le magnétomètre de type SQUID possède un bruit semblable mais il requiert un refroidissement cryogénique de l'élément sensible qui contient des éléments nécessitant d'être supraconducteurs pour son fonctionnement, ce qui restreint son champ d'application pratique.

On distingue deux grandes catégories de magnétomètres à pompage optique selon le type de pompage réalisé.

Dans la catégorie la plus répandue, le pompage est réalisé avec un faisceau de pompe émettant une lumière à polarisation circulaire et le gaz atomique acquiert un état dit orienté caractérisé par une valeur moyenne non nulle de son moment magnétique selon un axe, qui se trouve être celui de propagation du faisceau de pompe.

Dans l'autre catégorie, le pompage est réalisé avec un faisceau de pompe émettant une lumière en polarisation linéaire et le gaz atomique acquiert un état dit aligné caractérisé par une valeur nulle de son moment magnétique, mais par une valeur non nulle d'une grandeur du type (3 F_{z}² - F²) où F est le moment cinétique total et F_{z} le moment cinétique le long de la direction de polarisation du faisceau de pompage.

La caractérisation des états atomiques (étape 3 ci-dessus) peut être réalisée selon au moins deux schémas :
- en mesurant l'absorption d'un faisceau accordé (ou très proche) à la transition atomique considérée (le faisceau utilisé pour le pompage ou un faisceau dit « sonde » de même polarisation que le faisceau utilisé pour le pompage) ;
- en utilisant un faisceau dit « sonde » de polarisation linéaire et décalé en longueur d'onde par rapport à la transition atomique considérée. Selon le type de polarisation atomique (orientation ou alignement), ce faisceau subit une modification de sa polarisation (rotation du plan de polarisation dans le cas de l'orientation, création d'une composante polarisée circulairement dans le cas de l'alignement) qui peut être mesurée en séparant deux des états de polarisation du faisceau (les deux polarisations à 45° dans le cas de l'orientation, les deux polarisations circulaires dans le cas de l'alignement) puis en les photo-détectant de manière à identifier l'accroissement d'une des polarisations par rapport à l'autre. On parle alors de mesure polarimétrique.

Deux effets physiques permettent de réaliser une mesure vectorielle du champ magnétique. Il s'agit de l'effet Hanle et des résonances paramétriques.

Le premier effet est principalement utilisé dans les magnétomètres en orientation et se décline sous différentes variantes pour être sondé, principalement en polarimétrie, à travers une mesure de rotation Faraday ou une modulation de la polarisation du faisceau de sonde. Son avantage principal est qu'il permet une mesure « tout-optique » d'une ou deux composantes du champ magnétique sans nécessiter l'application de champ(s) magnétique(s) radiofréquence (RF). Cependant les configurations Hanle en orientation nécessitent plusieurs faisceaux lasers (de pompe et de sonde) se propageant orthogonalement les uns aux autres et souffrent donc d'un manque de compacité.

Les résonances paramétriques sont utilisées dans les magnétomètres en orientation et en alignement, principalement en absorption. La différence avec l'effet Hanle réside dans l'application de champs magnétiques radiofréquences sur la cellule contenant l'élément sensible qui permettent de faire apparaître des dépendances linéaires de certaines composantes fréquentielles du signal de photodétection en fonction des composantes du champ magnétique.

L'avantage de ce dernier type d'architecture est qu'une mesure d'une ou plusieurs composantes du champ magnétique peut être réalisée en utilisant un seul faisceau laser agissant comme pompe et sonde, permettant ainsi de réaliser des magnétomètres plus compacts. L'utilisation de cet effet est ainsi souvent préférée pour des applications médicales du type magnétoencéphalographie ou magnétocardiographie qui nécessitent une forte densité de capteurs sur la zone étudiée. Cependant, dans l'architecture usuelle des magnétomètres à résonance paramétrique en alignement la sensibilité à la composante du champ magnétique parallèle à la direction linéaire de la polarisation du faisceau laser est très dégradée par rapport à celle des deux autres composantes. Le bruit dont est assortie la mesure du champ selon ce troisième axe induit de fortes incertitudes sur les grandeurs de ces sources ou leur localisation, notamment pour les applications biomédicales, alors que si les trois composantes étaient sujettes au même bruit cette incertitude serait réduite de près d'un ordre de grandeur.

Un type de pompage rarement utilisé dans le domaine de la magnétométrie à pompage optique est celui du pompage en polarisation elliptique, à savoir une polarisation qui correspond à la superposition d'une polarisation linéaire et d'une polarisation circulaire. Une telle polarisation elliptique permet d'obtenir simultanément un état orienté et un état aligné dans le gaz atomique, en proportion du degré d'ellipticité de la lumière de pompage et lorsque les états atomiques le permettent (i.e. sur un état possédant un moment cinétique total supérieur ou égal à 1).

Une telle polarisation elliptique a été adoptée dans l'architecture décrite dans la demande de brevet EP 3 524 990 afin de bénéficier d'une meilleure sensibilité sur le troisième axe de mesure. Cette architecture nécessite l'application de trois champs radiofréquence et requiert pour analyser les propriétés optiques du milieu atomique de séparer les bases circulaires et linéaires de la lumière.

### EXPOSÉ DE L'INVENTION

L'invention a pour objectif de fournir un magnétomètre à résonance paramétrique offrant un niveau de bruit réduit selon le troisième axe de mesure et plus simple à mettre en œuvre que celui décrit dans la demande EP 3 524 990 A1.

L'invention propose à cet effet un magnétomètre à résonance paramétrique comprenant :
- une cellule remplie d'un gaz atomique ;
- une source de pompage optique agencée pour émettre en direction de la cellule un faisceau de lumière ;
- un dispositif de polarisation du faisceau de lumière configuré de sorte à ce que sous l'effet du faisceau de lumière le gaz atomique acquiert simultanément un état aligné selon une direction d'alignement et un état orienté selon une direction d'orientation ;
- une source d'excitation de résonances paramétriques configurée de manière à générer un champ magnétique radiofréquence dans la cellule ;
- un dispositif de détection de résonances paramétriques configuré pour mesurer l'absorption du faisceau de lumière par le gaz atomique.

La source d'excitation des résonances paramétriques est configurée de sorte que le champ magnétique radiofréquence généré dans la cellule est constituée de deux composantes orthogonales entre elles et oscillant chacune à sa propre fréquence d'oscillation.

Le faisceau de lumière traverse la cellule selon une direction de propagation, le dispositif de polarisation étant configuré de sorte que la direction d'alignement est orthogonale à la direction de propagation du faisceau de lumière et la direction d'orientation est longitudinale à la direction de propagation du faisceau de lumière et la source d'excitation des résonances paramétriques est configurée de sorte que lesdites deux composantes comprennent une composante longitudinale à la direction d'orientation et une composante longitudinale à la direction d'alignement.

Certains aspects préférés mais non limitatifs de ce magnétomètre sont les suivants :
- la fréquence d'oscillation de la composante longitudinale à la direction d'alignement est supérieure à la fréquence d'oscillation de la composante longitudinale à la direction d'orientation ;
- il est tel que 0,1 < *γB*₁/*ω* < 1,2 et 0,1 < *γB*₂/Ω < 1,2, avec B₁ l'amplitude de la composante longitudinale à la direction d'alignement, *ω*/2*π* la fréquence d'oscillation de la composante longitudinale à la direction d'alignement, B₂ l'amplitude de la composante longitudinale à la direction d'orientation, Ω/2*π* la fréquence d'oscillation de la composante longitudinale à la direction d'orientation et y le rapport gyromagnétique du gaz atomique ;
- il comprend en outre un photodétecteur agencé pour recevoir le faisceau de lumière ayant traversé la cellule et délivrer un signal de photodétection au dispositif de détection de résonances paramétriques ;
- le dispositif de détection de résonances paramétriques est configuré pour réaliser une détection synchrone du signal de photodétection à un harmonique de la fréquence d'oscillation de chacune des deux composantes et à un inter-harmonique des fréquences d'oscillation des deux composantes ;
- le dispositif de polarisation est configuré de manière à conférer une polarisation elliptique au faisceau de lumière ;
- le dispositif de polarisation comprend un polariseur linéaire présentant un axe de transmission suivi d'une lame quart d'onde présentant des axes neutres dont l'un est parallèle à la direction d'alignement ;
- l'axe de transmission du polariseur linéaire est tourné d'un angle compris entre 21° et 31° par rapport à celui des axes neutres de la lame quart d'onde qui est parallèle à la direction d'alignement.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

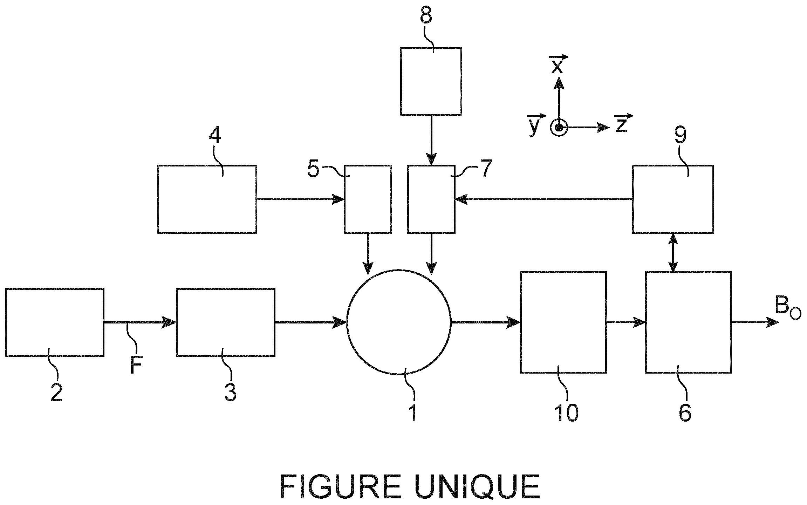

- la figure 1 est un schéma d'un magnétomètre conforme à l'invention.

### DESCRIPTION DES MODES DE RÉALISATION

En référence à la figure 1, l'invention porte sur un magnétomètre à pompage optique qui comprend une cellule 1 remplie d'un gaz atomique, par exemple de l'hélium-4 ou un gaz alcalin, soumis à un champ magnétique ambiant B₀ dont la projection sur trois axes de coordonnées rectangulaires x̅, y̅ et z̅ en définit trois composantes. Le champ magnétique ambiant B₀ se décompose ainsi en trois composantes Bₓ, B_{y} et B_{z} chacune selon l'un des axes de mesure du magnétomètre X, Y et Z. Le magnétomètre selon l'invention est plus particulièrement un magnétomètre vectoriel tri-axe, i.e. apte à réaliser une mesure de chacune des trois composantes Bₓ, B_{y} et B_{z} du champ magnétique ambiant.

La cellule est éclairée par une source de pompage optique 2 apte à émettre en direction de la cellule 1 un faisceau de lumière F, par exemple un faisceau laser, accordé à une longueur d'onde de pompage (ce faisceau est ainsi également désigné par faisceau de pompe). La longueur d'onde de pompage est calée sur une raie de transition atomique, par exemple sur la raie D₀ à 1083 nm dans le cas de l'hélium-4.

Utiliser un faisceau de pompe accordé sur la transition atomique utilisée pour le pompage optique permet de s'affranchir des effets indésirables du phénomène connu comme « light-shift », notamment du « light-shift » dit vectoriel qui apparaît lorsque les atomes sont illuminés par une lumière polarisée circulairement et non-résonante avec une transition atomique et également du « light-shift » dit tensoriel qui a pour effet de coupler alignement et orientation.

Dans le cas où l'élément sensible est l'hélium-4, le magnétomètre 10 comporte par ailleurs un système de décharge haute fréquence (HF), comprenant un générateur HF 4 et des bobines de surtension 5, pour amener les atomes du gaz atomique dans un état énergisé où ils sont aptes à subir la transition atomique lorsqu'ils sont éclairés par le faisceau laser, typiquement dans l'état métastable 2³S₁.

Dans le cadre de l'invention, le faisceau de lumière F utilisé pour le pompage (i.e. la préparation des états atomiques nécessaires à une mesure du champ magnétique) est également utilisé en tant que faisceau de sonde pour la détection des états atomiques induits par le pompage, son absorption par les atomes portant en effet une information sur la valeur des composantes du champ magnétique statique auquel est soumis la cellule. Le faisceau F se propage selon une direction de propagation qui sur la figure 1 est orientée selon la direction *̅z̅*̅.

Le magnétomètre comprend également un circuit d'excitation de résonances paramétriques qui comporte un générateur de radiofréquence 8 qui alimente des bobines d'Helmholtz 7 d'axes orthogonaux qui entourent la cellule afin de générer un champ magnétique d'excitation des résonances paramétriques, également désigné par champ magnétique radiofréquence. Le magnétomètre comprend par ailleurs un dispositif de détection de résonances paramétriques 6 configuré pour mesurer l'absorption du faisceau de lumière par le gaz atomique et un photodétecteur 10 agencé pour recevoir le faisceau de lumière ayant traversé la cellule et délivrer un signal de photodétection audit dispositif de détection de résonances paramétriques 6.

L'ensemble cellule 1 et bobines 7 est placé au sein d'un blindage magnétique passif en µ-métal afin de l'isoler des champs magnétiques ambiants (champ terrestre et perturbations électromagnétiques), trop intenses pour respecter la condition physique *γB*₀ « Γ nécessaire à l'apparition des résonances paramétriques où y désigne le rapport gyromagnétique des atomes du gaz atomique et Γ le taux de relaxation des atomes du gaz atomique.

Le magnétomètre peut également comprendre un système d'asservissement en boucle fermé du magnétomètre pour venir constamment soumettre l'élément sensible à un champ magnétique total nul. Le système d'asservissement comprend un régulateur 9 couplé au dispositif de détection 6 et qui injecte un courant dans les bobines de Helmholtz 7 afin de générer un champ magnétique de compensation Bc tel que la somme Bc+B₀ est maintenue à zéro en permanence.

Alternativement, le magnétomètre peut être opéré en boucle ouverte, sans compensation du champ ambiant.

Le faisceau de lumière F est polarisé au moyen d'un dispositif de polarisation 3 du faisceau de lumière. Ce dispositif 3, intercalé entre la source de pompage optique 2 et la cellule 1 ou directement intégré à la source de pompage optique, permet de conférer une polarisation bien spécifique à la lumière avant qu'elle ne traverse la cellule.

Dans un exemple de réalisation, le faisceau de lumière est un faisceau laser transporté par une fibre optique à l'extrémité de laquelle il diverge avec un angle dépendant de l'ouverture numérique de la fibre utilisée. Ce faisceau divergent est collimaté avant de traverser la cellule, par exemple en utilisant une lentille convergente. A la sortie de cet ensemble permettant la collimation, le faisceau passe à travers le dispositif de polarisation 3. Après passage dans la cellule, le faisceau laser passe à travers une lentille dite de projection qui permet d'expanser (lentille divergente) ou de focaliser (lentille convergente) le faisceau collimaté sur le photodétecteur 10.

Dans le cadre de l'invention, le dispositif de polarisation 3 est plus particulièrement configuré de sorte à ce que sous l'effet du faisceau de lumière le gaz atomique acquiert simultanément un état aligné selon une direction d'alignement et un état orienté selon une direction d'orientation.

Le dispositif de polarisation 3 peut ainsi être configuré pour conférer simultanément une polarisation linéaire et une polarisation circulaire au faisceau de lumière, le faisceau émis en direction de la cellule étant dès lors polarisé elliptiquement.

Une telle polarisation elliptique a pour effet de préparer les états atomiques selon une orientation et un alignement résultant à la fois d'une polarisation linéaire et d'une polarisation circulaire. Ainsi, l'état que les atomes du gaz atomique dans la cellule acquièrent est à la fois aligné (selon une direction d'alignement) et orienté (selon une direction d'orientation), en proportion au degré d'ellipticité de la polarisation. L'état des atomes se décompose plus particulièrement en une orientation le long de la direction de propagation du faisceau de lumière et un alignement principalement dirigé le long de l'axe vertical, orthogonal à la direction de propagation du faisceau de pompe (l'alignement comportant une faible proportion longitudinale à la direction de propagation du faisceau de pompe due au pompage avec une lumière en partie polarisée circulairement sur un état atomique de moment cinétique total supérieur ou égal à 1). La direction d'orientation est ainsi longitudinale à la direction de propagation (i.e. selon la direction *̅z̅*̅) tandis que la direction d'alignement est orthogonale à la direction de propagation (selon la direction *̅x̅*̅ dans le repère de la figure 1).

Un tel dispositif de polarisation 3 conférant une polarisation elliptique au faisceau de lumière peut comprendre un polariseur linéaire et une lame quart d'onde dont les axes neutres sont tournés à un angle différent de 45° par rapport à l'axe de transmission du polariseur linéaire. Plus particulièrement, l'un des axes neutres (lent ou rapide) de la lame quart d'onde est parallèle à la direction d'alignement (i.e. la direction *̅x̅*̅). Le polariseur linéaire est placé avant la lame quart d'onde sur le trajet optique. Le dispositif de polarisation 3 vient ainsi conférer une polarisation elliptique caractérisée par un demi-grand axe de l'ellipse qui se retrouve aligné avec celui des axes neutres de la lame quart d'onde qui forme le plus petit angle avec l'axe de transmission du polariseur linéaire placé avant la lame quart d'onde. On choisit par exemple une configuration pour laquelle le demi-grand axe de l'ellipse se retrouve aligné avec la direction d'alignement.

L'axe de transmission du polariseur linéaire est de préférence tourné d'un angle compris entre 21° et 31°, par exemple de 26°, par rapport à celui des axes neutres de la lame quart d'onde qui est parallèle à la direction d'alignement. Le demi-grand axe de l'ellipse se retrouve ainsi aligné avec la direction d'alignement. Le choix de cette gamme d'angle se justifie par ailleurs par une imprécision de +/- 5° sur la fixation de la valeur de 26° dans des configurations miniatures où cet angle est fixé par collage. Les inventeurs ont pu vérifier dans des configurations de laboratoire où cet angle peut être fixé précisément que cette gamme d'angle permet d'obtenir des signaux de sensibilité particulièrement favorable selon les critères qui seront détaillés ci-après.

Alternativement, le dispositif de polarisation 3 peut être configuré pour conférer alternativement une polarisation linéaire puis une polarisation circulaire. Un tel polariseur 3 peut comprendre un polariseur linéaire et une lame de retard contrôlable électriquement. Cette lame est modulée avec une onde carrée de manière à ce que pendant les demi-périodes où son niveau de sortie est haut (noté SH), elle se comporte comme une lame quart d'onde, alors que pendant les demi-périodes de niveau bas (noté SL) elle se comporte comme une lame sans retard ou comme une lame demi-onde. Ainsi, pendant les demi-périodes SH, le faisceau émis en direction de la cellule est polarisé circulairement et les états atomiques dans la cellule sont orientés. Et pendant les demi-périodes SL, le faisceau émis en direction de la cellule est polarisé linéairement et les états atomiques dans la cellule sont alignés. La dynamique des atomes étant dominée par un temps de relaxation de l'ordre de 1 ms, en adoptant une modulation SL/SH plus rapide, les atomes sont placés dans une superposition des états alignés et orientés. Il ne s'agit donc pas d'un passage successif par ces deux états mais de la concomitance des deux propriétés.

Contrairement au magnétomètre décrit dans la demande EP 3 524 990 qui nécessite un champ magnétique radiofréquence comportant trois composantes, celui selon l'invention n'en requiert que deux. La source d'excitation des résonances paramétriques du magnétomètre selon l'invention est ainsi configurée pour que le champ magnétique radiofréquence généré dans la cellule au moyen des bobines d'Helmholtz 7 présente deux composantes orthogonales entre elles et oscillant chacune à sa propre fréquence d'oscillation. Lesdites composantes comprennent plus particulièrement une composante longitudinale à la direction d'orientation (selon *̅z̅*̅) et une composante longitudinale à la direction d'alignement (selon *̅x̅*̅).

Ainsi, une première composante B₁*̅x̅*̅cos(ωt) de fréquence *ω*/*2π* est appliquée selon la direction principale de l'alignement atomique et une deuxième composante B₂*̅z̅*̅cos(Ωt) de fréquence Ω/2π est appliquée selon la direction d'orientation des atomes (i.e. direction de propagation du faisceau de pompage). La première composante contrôle l'évolution de l'orientation atomique (et du résidu d'alignement dirigé selon cette direction d'orientation) et permet la mesure de la composante du champ magnétique parallèle à la direction principale de l'alignement atomique. La deuxième composante contrôle l'évolution de l'alignement atomique transverse et permet la mesure de la composante du champ magnétique parallèle à la direction de propagation du faisceau de pompe.

La fréquence *ω*/*2π* de la première composante est de préférence supérieure à la fréquence Ω/2π de la deuxième composante pour que les dynamiques des états atomiques pompés optiquement par chaque composante du champ radiofréquence soient découplés du point de vue temporel. La dynamique dans la composante rapide à la fréquence *ω*/*2π* doit ainsi être « trop » rapide pour la composante lente à la fréquence Ω/2π afin de ne pas affecter la dynamique des spins dans cette dernière. Cette dynamique dans la composante lente doit elle-même être « trop » rapide devant la dynamique propre des spins (taux de relaxation Γ) et celle dans le champ statique B₀ à mesurer (fréquence de Larmor *f_{L} = γB*₀)*.*

On prévoit en outre que la composante de champ RF rapide (*ω*) soit appliquée selon l'axe *̅x̅*̅ (direction du demi grand-axe de l'ellipse) et que la composante lente (Ω) soit dirigée selon l'axe *̅z̅*̅, direction de propagation du faisceau laser. Les inventeurs ont effectivement pu vérifier que si les composantes de champ RF devaient être inversées, les sensibilités au point de fonctionnement isotrope obtenu seraient inférieures.

Les rapports *γB*₁/*ω* et *γB*₂/Ω (avec y le rapport gyromagnétique du gaz atomique, par exemple y = 2π × 28 rad/nT.s pour l'état 2³S₁ de l'hélium-4) qui contrôlent la sensibilité de la mesure du champ magnétique sont de préférence fixés tels que 0.1 < *γB*₁/*ω* < 1.2 et 0.1 < *γB*₂/Ω < 1.2. On assure de telle manière l'existence d'un point de fonctionnement où la sensibilité de chaque axe de mesure représente entre 30% et 37% de la somme de la sensibilité sur les trois axes, pour des angles de 21° à 31°.

Dans l'invention, le dispositif de détection de résonances paramétriques 6 configuré pour mesurer l'absorption du faisceau de lumière par le gaz atomique vient mesurer la lumière transmise par les atomes sur la base elliptique, i.e. uniquement avec un photodétecteur et éventuellement une optique de collimation en sortie de cellule, et ainsi sans ajout d'éléments optiques intermédiaires permettant de séparer les bases linéaires et circulaires de la lumière entre la cellule contenant l'élément sensible et le photodétecteur comme cela est le cas pour le magnétomètre décrit dans la demande EP 3 524 990.

Pour déterminer une mesure de chacune des trois composantes du champ magnétique ambiant, le dispositif de détection de résonances paramétriques 6 est configuré pour réaliser une détection synchrone du signal de photodétection à un harmonique de chacune des fréquences d'oscillation (*ω* et Ω) et à un inter-harmonique desdites fréquences d'oscillation (*ω* ± Ω). Une démodulation du signal de photodétection à la fréquence *ω* permet une mesure de la composante du champ magnétique parallèle à la direction principale d'alignement des atomes (Bₓ), une démodulation à la fréquence Ω permet une mesure de la composante du champ magnétique parallèle à la direction de propagation du faisceau de pompe (B_{z}). La dernière composante du champ magnétique (B_{y}), celle orthogonale à la direction d'application des deux composantes du champ radiofréquence, est obtenue en démodulant le signal de photodétection à une des inter-harmoniques *ω* ± Ω.

Dans un exemple de réalisation, l'angle entre l'axe propre de la lame quart d'onde parallèle à la direction *̅x̅*̅ et l'axe de transmission du polariseur linéaire est fixé à 26°, la fréquence *ω*/2*π* est fixée à 40 kHz, la fréquence Ω/2π est fixée à 15 kHz. Les rapports *γB*₁/*ω* et *γB*₂/Ω sont fixés respectivement à 0.97 et 0.76, correspondant à des amplitudes des composantes du champ radiofréquence B₁ = 1385 nT et *B*₂ = 407 nT.

Dans un autre exemple de réalisation, l'angle entre l'axe propre de la lame quart d'onde parallèle à la direction *̅x̅*̅ et l'axe de transmission du polariseur linéaire est fixé à 26°, la fréquence *ω*/2*π* est fixée à 40 kHz, la fréquence Ω/2π est fixée à 9 kHz. Les rapports *γB*₁/*ω* et *γB*₂/Ω sont fixés respectivement à 0.76 et 0.99, correspondant à des amplitudes des composantes du champ radiofréquence B₁ = 1085 nT et B₂ = 530 nT. Dans cette réalisation, la sensibilité à chaque axe est légèrement plus faible que dans l'exemple précédent mais elle est parfaitement isotrope.

## Revendications

1. Magnétomètre à résonance paramétrique comprenant :
- une cellule (1) remplie d'un gaz atomique ;
- une source de pompage optique (2) agencée pour émettre en direction de la cellule (1) un faisceau de lumière (F) ;
- un dispositif de polarisation (3) du faisceau de lumière configuré de sorte à ce que sous l'effet du faisceau de lumière le gaz atomique acquiert simultanément un état aligné selon une direction d'alignement (*̅x̅*̅) et un état orienté selon une direction d'orientation (*̅z̅*̅);
- une source d'excitation de résonances paramétriques (7, 8) configurée de manière à générer un champ magnétique radiofréquence dans la cellule ;
- un dispositif de détection de résonances paramétriques (6) configuré pour mesurer l'absorption du faisceau de lumière par le gaz atomique ;
**caractérisé en ce que** la source d'excitation des résonances paramétriques (7, 8) est configurée de sorte que le champ magnétique radiofréquence généré dans la cellule est constituée de deux composantes orthogonales entre elles et oscillant chacune à sa propre fréquence d'oscillation, et **en ce que** le faisceau de lumière traverse la cellule selon une direction de propagation, le dispositif de polarisation étant configuré de sorte que la direction d'alignement est orthogonale à la direction de propagation du faisceau de lumière et la direction d'orientation est longitudinale à la direction de propagation du faisceau de lumière et la source d'excitation des résonances paramétriques est configurée de sorte que lesdites deux composantes comprennent une composante longitudinale à la direction d'orientation et une composante longitudinale à la direction d'alignement.

2. Magnétomètre selon la revendication 1, dans lequel la fréquence d'oscillation de la composante longitudinale à la direction d'alignement est supérieure à la fréquence d'oscillation de la composante longitudinale à la direction d'orientation.

3. Magnétomètre selon la revendication 2, dans lequel 0,1 *< γB*₁/*ω* < 1,2 et 0,1 < *γB*₂/Ω < 1,2, avec B₁ l'amplitude de la composante longitudinale à la direction d'alignement, *ω*/*2π* la fréquence d'oscillation de la composante longitudinale à la direction d'alignement, B₂ l'amplitude de la composante longitudinale à la direction d'orientation, Ω/2π la fréquence d'oscillation de la composante longitudinale à la direction d'orientation et y le rapport gyromagnétique du gaz atomique.

4. Magnétomètre selon l'une des revendications précédentes, comprenant en outre un photodétecteur (10) agencé pour recevoir le faisceau de lumière (L) ayant traversé la cellule et délivrer un signal de photodétection au dispositif de détection de résonances paramétriques (6).

5. Magnétomètre selon la revendication 4, dans lequel le dispositif de détection de résonances paramétriques (6) est configuré pour réaliser une détection synchrone du signal de photodétection à un harmonique de la fréquence d'oscillation de chacune des deux composantes et à un inter-harmonique des fréquences d'oscillation des deux composantes.

6. Magnétomètre selon l'une des revendications précédentes, dans lequel le dispositif de polarisation est configuré de manière à conférer une polarisation elliptique au faisceau de lumière.

7. Magnétomètre selon la revendication 6, dans lequel le dispositif de polarisation comprend un polariseur linéaire présentant un axe de transmission suivi d'une lame quart d'onde présentant des axes neutres dont l'un est parallèle à la direction d'alignement.

8. Magnétomètre selon la revendication 7, dans lequel l'axe de transmission du polariseur linéaire est tourné d'un angle compris entre 21° et 31° par rapport à celui des axes neutres de la lame quart d'onde qui est parallèle à la direction d'alignement.

## Patentansprüche

1. Magnetometer mit parametrischer Resonanz, umfassend:
- eine Zelle (1), die mit einem Atomgas gefüllt ist;
- eine optische Pumpenquelle (2), die angeordnet ist, um in Richtung der Zelle (1) einen Lichtstrahl (F) auszugeben;
- eine Polarisationsvorrichtung (3) des Lichtstrahls, die derart konfiguriert ist, dass das Atomgas unter der Wirkung des Lichtstrahls gleichzeitig einen Zustand, der in einer Justierungsrichtung (*̅x̅*̅) justiert ist, und einen Zustand, der in einer Orientierungsrichtung (*̅z̅*̅) orientiert ist, erfasst;
- eine Quelle zur Anregung parametrischer Resonanzen (7, 8), die derart konfiguriert ist, um ein Funkfrequenz-Magnetfeld in der Zelle zu erzeugen;
- eine Vorrichtung zum Erkennen von parametrischen Resonanzen (6), die konfiguriert ist, um die Absorption des Lichtstrahls durch das Atomgas zu messen;
**dadurch gekennzeichnet, dass** die Quelle zur Anregung parametrischer Resonanzen (7, 8) derart konfiguriert ist, dass sich das in der Zelle erzeugte Funkfrequenz-Magnetfeld aus zwei zueinander orthogonalen, und jeweils in ihrer eigenen Oszillationsfrequenz oszillierenden Komponenten zusammensetzt, und dadurch, dass der Lichtstrahl die Zelle in einer Ausbreitungsrichtung durchquert, wobei die Polarisationsvorrichtung derart konfiguriert ist, dass die Justierungsrichtung orthogonal zur Ausbreitungsrichtung des Lichtstrahls ist und die Orientierungsrichtung längs zur Ausbreitungsrichtung des Lichtstrahls ist und die Quelle zur Anregung parametrischer Resonanzen derart konfiguriert ist, dass die beiden Komponenten eine Komponente längs zur Orientierungsrichtung und eine Komponente längs zur Justierungsrichtung umfassen.

2. Magnetometer nach Anspruch 1, wobei die Oszillationsfrequenz der Komponente längs zur Justierungsrichtung höher als die Oszillationsfrequenz der Komponente längs zur Orientierungsrichtung ist.

3. Magnetometer nach Anspruch 2, wobei 0,1 < *γB*1/*ω* < 1,2 ist, und 0,1 < *γB*₂/Ω < 1,2 ist, mit *B*₁ als Amplitude der Komponente längs zur Justierungsrichtung, ω/2*π* als Oszillationsfrequenz der Komponente längs zur Justierungsrichtung, B₂ als Amplitude der Komponente längs zur Orientierungsrichtung, Ω/2π als Oszillationsfrequenz der Komponente längs zur Orientierungsrichtung und y als gyromagnetischem Verhältnis des Atomgases.

4. Magnetometer nach einem der vorstehenden Ansprüche, weiter einen Fotodetektor (10) umfassend, der angeordnet ist, um den Lichtstrahl (L) zu empfangen, der die Zelle durchquert hat, und ein Fotodetektionssignal an die Vorrichtung zum Erkennen parametrischer Resonanzen (6) abzugeben.

5. Magnetometer nach Anspruch 4, wobei die Vorrichtung zum Erkennen von parametrischen Resonanzen (6) konfiguriert ist, um eine synchrone Erkennung des Fotodetektionssignals mit einer harmonischen Schwingung der Oszillationsfrequenz jeder der beiden Komponenten und mit einer zwischenharmonischen Schwingung der Oszillationsfrequenzen jeder der beiden Komponenten zu realisieren.

6. Magnetometer nach einem der vorstehenden Ansprüche, wobei die Polarisationsvorrichtung derart konfiguriert ist, um dem Lichtstrahl eine elliptische Polarisation zu verleihen.

7. Magnetometer nach Anspruch 6, wobei die Polarisationsvorrichtung einen Linearpolarisator umfasst, der eine Übertragungsachse, gefolgt von einem Viertelwellenplättchen aufweist, das neutrale Achsen aufweist, von denen eine parallel zur Justierungsrichtung verläuft.

8. Magnetometer nach Anspruch 7, wobei die Übertragungsachse des Linearpolarisators um einen Winkel gedreht ist, der zwischen 21° und 31° in Bezug auf jenen der neutralen Achsen des Viertelwellenplättchens liegt, das parallel zur Justierungsrichtung verläuft.

## Claims

1. A parametric resonance magnetometer comprising:
- a cell (1) filled with an atomic gas;
- an optical pumping source (2) arranged so as to emit a light beam (F) in the direction of the cell (1);
- a device for polarising (3) the light beam configured so that by the effect of the light beam, the atomic gas simultaneously acquires a state aligned according to an alignment direction (*̅x̅*̅) and a state oriented according to an orientation direction (*̅z̅*̅);
- a parametric resonance excitation source (7, 8) configured so as to generate a radiofrequency magnetic field in the cell;
- a device for detecting parametric resonances (6) configured so as to measure the absorption of the light beam by the atomic gas;
**characterized in that** the parametric resonance excitation source (7, 8) is configured so that the radiofrequency magnetic field generated in the cell consists of two components orthogonal to one another and each oscillating at its natural oscillation frequency, and wherein the light beam crosses the cell according to a direction of propagation, the polarisation device being configured so that the alignment direction is orthogonal to the direction of propagation of the light beam and the orientation direction is longitudinal to the direction of propagation of the light beam and the parametric resonance excitation source is configured so that said two components comprise a component longitudinal to the orientation direction at a direction longitudinal to the alignment direction.

2. The magnetometer according to claim 1, wherein the oscillation frequency of the component longitudinal to the alignment direction is higher than the oscillation frequency of the component longitudinal to the orientation direction.

3. The magnetometer according to claim 2, wherein 0.1 < *γB*₁/*ω* < 1.2 and 0.1 < *γB*₂/Ω < 1.2, with B₁ the amplitude of the component longitudinal to the alignment direction, *ω*/*2π* the oscillation frequency of the component longitudinal to the alignment direction, B₂ the amplitude of the component longitudinal to the orientation direction, Ω/2π the oscillation frequency of the component longitudinal to the orientation direction and y the gyromagnetic ratio of the atomic gas.

4. The magnetometer according to one of previous claims, further comprising a photodetector (10) arranged so as to receive the light beam (L) having crossed the cell and to output a photodetection signal to the parametric resonance detection device (6).

5. The magnetometer according to claim 4, wherein the parametric resonance detection device (6) is configured so as to carry out a synchronous detection of the photodetection signal at a harmonic of the oscillation frequency of each of the two components and at an inter-harmonic of the oscillation frequencies of the two components.

6. The magnetometer according to one of previous claims, wherein the polarisation device is configured so as to confer an elliptical polarisation on the light beam.

7. The magnetometer according to claim 6, wherein the polarisation device comprises a linear polariser having a transmission axis followed by a quarter-wave plate having neutral axes one of which his parallel to the alignment direction.

8. The magnetometer according to claim 7, wherein the transmission axis of the linear polariser is rotated by an angle comprised between 21° and 31° with respect to that amongst the neutral axes of the quarter-wave plate that is parallel to the alignment direction.
